(19) Europäisches Patentamt
European Patent Office
Office européen des brevets

(11) Publication number: 0 520 515 B1

# EUROPEAN PATENT SPECIFICATION

(45) Date of publication of patent specification: 29.11.95

(51) Int. Cl.⁶: C09J 7/02, C08L 53/00

(21) Application number: 92110997.1

(22) Date of filing: 29.06.92

(54) Semiconductor wafer-securing adhesive tape.

(30) Priority: 28.06.91 JP 185397/91
18.03.92 JP 92093/92
18.03.92 JP 92094/92
18.03.92 JP 113928/92

(43) Date of publication of application:
30.12.92 Bulletin 92/53

(45) Publication of the grant of the patent:
29.11.95 Bulletin 95/48

(84) Designated Contracting States:
DE FR GB IT NL

(56) References cited:

DATABASE WPIL Week 9114, 28 August 1990
Derwent Publications Ltd., London, GB; AN
096638

DATABASE WPIL Week 9005, 13 December
1989 Derwent Publications Ltd., London, GB;
AN 032543

(73) Proprietor: THE FURUKAWA ELECTRIC CO.,
LTD.
6-1, Marunouchi 2-chome
Chiyoda-ku
Tokyo 100 (JP)

(72) Inventor: Nakayama, Koji
14-22, Nakahara 2-chome
Hiratsuka-shi,
Kanagawa-ken (JP)
Inventor: Mougi, Kenji
528-2, Sanda
Atsugi-shi,
Kanagawa-ken (JP)
Inventor: Shiramatsu, Eiji
1-34, Shinhara-machi,
Moji-ku
Kitakyushu-shi,
Fukuoka-ken (JP)
Inventor: Iwamoto, Kazushige
16-10, Sumiredaira
Hiratsuka-shi,
Kanagawa-ken (JP)
Inventor: Ishiwata, Shinichi
16-10, Sumiredaira
Hiratsuka-shi,
Kanagawa-ken (JP)
Inventor: Hasebe, Morikuni
23-201 Hanezawa-danchi,
Endo
Fujisawa-shi,
Kanagawa-ken (JP)

(74) Representative: **Boeters, Hans Dietrich, Dr. et al**
**Patentanwälte Boeters & Bauer,**
**Bereiteranger 15**
**D-81541 München (DE)**

**Description**

FIELD OF THE INVENTION

The present invention relates to an adhesive tape that is used in a production line of various semiconductors, and more particularly to a radiation-curable adhesive tape for securing semiconductor wafers that is used, for example, when a wafer having circuit patterns formed thereon is cut into the individual patterns, thereby forming separate semiconductor chips.

BACKGROUND OF THE INVENTION

Hitherto, to carry out dicing for cutting a semiconductor wafer having circuit patterns formed thereon into separate chips, a system that uses a radiation-curable adhesive tape has been developed.

A process for producing semiconductor chips from a wafer is shown, for example, as follows:

(1) dicing (a wafer is secured by a strong adhesive force of adhesive tape and then is cut into separate chips),

(2) irradiation (the film side of the base is irradiated with radiation to lower the adhesive force of the adhesive tape),

(3) expanding (the adhesive tape is radially expanded to enlarge the interval between chips),

(4) picking up (each chip is picked up from the surface of the tape using a collet by vacuum suction and sticking up the tape from the back side of the tape).

Further, there is a process that the expanding (3) is carried out between the dicing (1) and the irradiation (2).

In this system, as the adhesive tape, an adhesive tape for securing a semiconductor wafer is used that is made up of a support film through which radiation, such as light, including ultraviolet rays or ionizing radiation, such as an electron beam, can transmit, and an adhesive layer that is coated on the support film and is characteristically curable by exposure to radiation. According to the system the adhesive force of the adhesive tape for securing chips in the dicing to make chips greater, and after the semiconductor wafer is cut and separated into chips, the adhesive force is lowered. Namely after the out and separation into chips, the film side of the support is irradiated with radiation to cure the radiation-curable adhesive layer, thereby lowering considerably the chip-securing adhesive force, so that, irrespective of the size of the chips, chips having a size, for example, of 25 mm$^2$ or over, can easily be picked up. This is because a radiation-curable compound contained in the adhesive layer of the semiconductor wafer-securing adhesive tape formed by applying a radiation-curable adhesive on a support film through which radiation can be transmitted is cured by irradiation with radiation to cause the adhesive to have a three-dimensional structure, thereby lowering the fluidity of the adhesive remarkably.

However, due to the three-dimensional structure, the rubber-like elasticity of the adhesive tape possessed at the time of dicing is eventually almost lost at the time of expanding after the curing. Consequently, a problem arises that the conventionally performed enlargement of the intervals between chips by radial expanding of the adhesive tape becomes difficult.

To solve the problem, the use of a soft polyvinyl chloride (PVC) as a central layer in a support film has already been put into practice. However, as polyvinyl chloride resins contain chlorine and further contains stabilizers, including metal compounds and plasticizers, on some occasions chlorine ions, metal ions, plasticizers, and the like bleed, to cause the surface of semiconductor wafers to be contaminated.

Therefore, as disclosed in Japanese Patent Application (OPI) No. 215528/1990, adhesive tapes are suggested which use a support film comprising a laminated film having a center layer made of a thermoplastic resin with rubber-like elasticity, such as a polybutene-1, a polyurethane, a polyester elastomer, a 1,2-polybutadiene, a hydrogenated styrene/isoprene/styrene copolymer, and a styrene/ethylene/butene/styrene (SEBS) copolymer . However, although any of these adhesive tapes can be enlarged by expanding before the irradiation with radiation to secure the interval between chips to only prevent contact of the chips, the following problems arise. That is, large and uniform intervals between chips are required in a picking up apparatus involving image recognition after irradiation with radiation. But any of above prior adhesive tapes does not satisfy this need sufficiently, because such problems as the occurrence of necking of the support film itself (the occurrence of partial extension due to failure of transmission of power at the time of expanding of the film) and the loss of rubber-like elasticity resulting from the deterioration of the support film due to the irradiation with radiation arise.

Individually, a polybutene-1, a polyester elastomer, and a 1,2-polybutadiene are liable to result in necking, thereby making impossible the enlargement of intervals between chips (like PVC); a polyurethane is too high in rubber-like elasticity, thereby leading to lack of uniformity in intervals between chips; and although hydrogenated styrene/isoprene/styrene copolymers are excellent in properties than the above polymers, they still cannot obviate the problem of necking, and they are attended with the defect that the expansion between chips is unsatisfactory. In Japanese Patent Application (OPI) No. 215528/1990, as a styrene/ethylene/butene/styrene (SEBS) copolymer, RABALON, manufactured by Mitsubishi Petrochemical Co., Ltd., is used in an Example, but Rabalon is blends of SEBS having a molecular weight of 100,000 or more with a polypropylene or ethylene/propylene/diene copolymers, and a compatibilizing agent bleeds into the adhesive layer, thereby making the adhesive force unstable, leading to such problems as the occurrence of picking up failure and contamination of the wafer. Further, in the case wherein only SEBS is used instead of its blend in the center layer, depending on the content of styrene and the molecular weight, such problems arise as, for example, necking causes insufficient intervals between chips, insufficient lowering the adhesive force after irradiation, or the transmission of radiation becomes poor.

## SUMMARY OF THE INVENTION

The object of the present invention is to provide a semiconductor wafer-securing adhesive tape that is free from the above problems.

That is, the first object of the present invention is to provide a semiconductor wafer-securing adhesive tape, wherein the adhesive tape has an adhesive force high enough to secure a semiconductor wafer before irradiation with radiation, which adhesive force for securing chips can be remarkably reduced after irradiation with radiation; the adhesive tape after irradiation with radiation retains its rubber-like elasticity (flexibility); and the expanding of the adhesive tape after irradiation with radiation can sufficiently and uniformly enlarge intervals between chips.

The second object of the present invention is to provide a semiconductor wafer-securing adhesive tape wherein such debris as fibrous swarfs do not occur at the dicing of the semiconductor wafer, and the adhesive of the adhesive tape does not contaminate the semiconductor chips.

The third object of the present invention is to provide a semiconductor wafer-securing adhesive tape wherein the tape has good interlaminar strength that can reduce a failure of picking up of chips caused by a partial ply separation of support film at the expanding of tape, and the tape has good heat-resistance that does not cause the breaking of support film.

The above and other objects, features, and advantages of the invention will become apparent in the following description, taken in connection with the accompanying drawings.

## BRIEF DESCRIPTION OF THE DRAWINGS

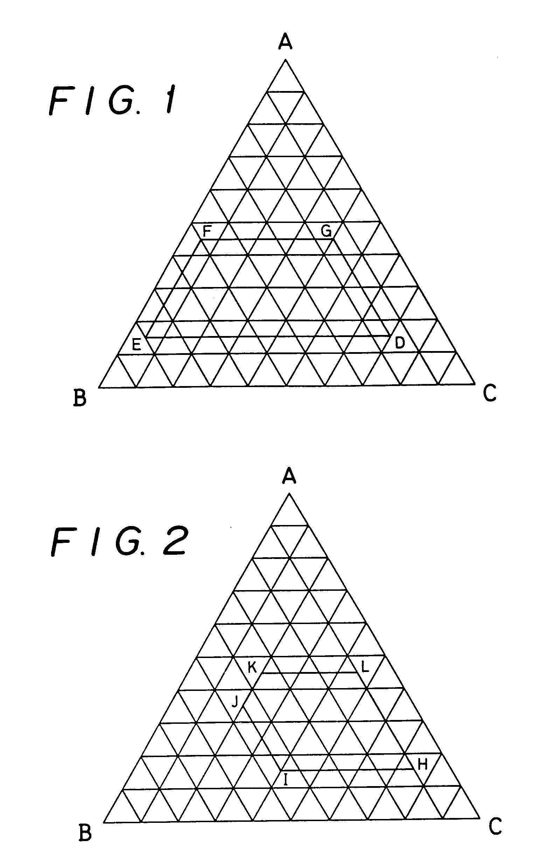

Fig. 1 and Fig. 2 each are triangular coordinate diagrams showing the constituent range of resin composition forming the center layer of support film of adhesive tape of this invention.

## DETAILED DESCRIPTION OF THE INVENTION

The present semiconductor wafer-securing adhesive tape comprises

(1) a semiconductor wafer-securing adhesive tape having a radiation-curable adhesive layer on one surface of a support film, wherein the support film is composed of a laminated film that comprises, as a center layer, a film comprising a styrene/ethylene/butene/styrene block-type copolymer having a styrene polymer block component (A) and an ethylene/butene copolymer block component (B), with the component (A) being 10 to 30 wt% of components (A) + (B), and having a weight-average molecular weight of 35,000 to 90,000; and has a layer for adhesive coating laid, directly or through a bonding layer, on one surface of the center layer on the side where said radiation-curable adhesive layer is provided and has a transfer-preventing layer laid on the other surface of the center layer, and

(2) a semiconductor wafer-securing adhesive tape having a radiation-curable adhesive layer on one surface of a support film, wherein the support film is composed of a laminated film that comprises, as a center layer, a film comprising a styrene/ethylene/pentene/styrene-block-type copolymer having a styrene polymer block component (A) and an ethylene/pentene copolymer block component (C) with the component (A) being 10 to 30 wt% of components (A) + (C), and having a weight-average molecular weight of 150,000 to 500,000, and has a layer for adhesive coating laid, directly or through a bonding layer, on one surface of the center layer on the side where said radiation-curable adhesive layer is provided and has a transfer-preventing layer laid on the other surface of the center layer.

In this specification and the claims, the term "adhesive tape" means a pressure-sensitive adhesive tape, and the term "adhesive" means a pressure-sensitive adhesive. Further, the term "radiation" refers to light, such as ultraviolet rays, or ionizing radiation, such as an electron beam.

In the first embodiment the center layer film consists essentially of the styrene/ethylene/butene/styrene block-type copolymer or the styrene/ethylene/pentene/styrene block-type copolymer.

In the styrene/ethylene/butene- or pentene/styrene block-type copolymer of the present invention, to enlarge the intervals between chips by radial expanding after the curing of the adhesive with irradiation with radiation, it is required that the content of the styrene polymer block component (A) be in the range of 10 to 30 wt%. If the content of the component (A) is less than 10 wt%, since the properties of the copolymer are close to those of a polyethylene, necking is apt to occur, thereby making uniform expanding impossible, so that the intervals between chips cannot be enlarged. If the content of the component (A) exceeds 30 wt%, ultraviolet rays cannot transmit through the block copolymer, so that the adhesive force after the irradiation cannot be lowered. As a result failure of picking up occurs, or wafers or chips are contaminated. Further, the rubber-like elasticity is low and it becomes difficult to increase the intervals between chips by uniform expanding.

Preferably, the glass transition temperature of the styrene polymer block component (A) is 20°C or higher, and preferably the glass transition temperature of the ethylene/butene copolymer block component (B) or the ethylene/pentene copolymer block component (C) is -20°C or below.

In the present invention, as the styrene/ethylene/butene or pentene/styrene block-type copolymer, styrene/ethylene/butene or pentene/styrene block copolymers modified by addition of or substitution by 1% or less of a low-molecular compound, such as maleic acid, containing a functional group such as a carboxyl group, can be used.

In the case of the copolymer of the components (A) and (B), the weight-average molecular weight of the copolymer is 35,000 to 90,000, preferably 40,000 to 80,000 more preferably 45,000 to 70,000. If that weight-average molecular weight is less than 35,000, the tensile strength is weak and there is a danger that breakage of the copolymer film will occur; whereas if it exceeds 90,000, the formability of the film becomes deteriorated because the molecules become entangled and expanding of the film becomes difficult.

In the case of the copolymer of the block components (A) and (C), the weight-average molecular weight is 150,000 to 500,000, preferably 170,000 to 400,000, more preferably 180,000 to 3000,000. This is because if the weight-average molecular weight is less than 150,000, the tensile strength is weak and there is a danger that breakage of the copolymer film will occur; whereas if it exceeds 500,000, the formability of the film becomes deteriorated because the molecules become entangled and expanding of the film becomes difficult.

According to another embodiment of the present invention, the center layer film comprises resin composition of the styrene/ethylene/butene/styrene (SEBS) block-type copolymer or styrene/ethylene/pentene/styrene (SEPS) block-type copolymer: 15 to 45 wt%, ethylene/acrylate-type copolymer: 15 to 80 wt%, and polyamide/polyether-type copolymer: 5 to 70 wt%.

In this embodiment, excellent effects can be attained wherein fibrous swarfs are not generated at the dicing, and the adhesive force is high enough to secure a semiconductor wafer and is reduced after irradiation with radiation while flexibility is retained. Further, other effects can be attained wherein the failure of picking up of chips is reduced because partial ply separation is prevented and the breaking of film due to heat at the picking up does not occur, with the result that chips can be picked up easily and without being damaged.

The resin composition of the film forming the center layer of radiation-curable adhesive tape of this embodiment can be shown by the quadrilateral tetragon surrounded by solid lines in Fig. 1. Fig. 1 is a triangular coordinate diagram showing the composition of three constituents, wherein each vertex A, B, and C of the triangle represents 100% of styrene/ethylene/butene or pentene copolymer (component a), 100% of ethylene/acrylate copolymer (component b), and 100% of polyamide/polyester copolymer (component c), respectively, and points D, E, F, and G each represent a boundary composition. That is, D represents a point of a = 15, b = 15, and c = 70 wt%, E represents a point of a = 15, b = 80, and c = 5 wt%, F represents a point of a = 45, b = 50, and c = 5 wt%, and G represents a point of a = 45, b = 15, and c = 40 wt%, and the quadrilateral tetragon obtained by connecting these points successively shows the range of resin composition by its inner area.

As a styrene/ethylene/butene/styrene block-type copolymer (SEBS) or styrene/ethylene/pentene/styrene block-type copolymer (SEPS) use can be made of those copolymers above-mentioned as SEBS and SEPS.

In this embodiment, the content of SEBS or SEPS is limited in a range from 15 to 45 wt%, because, when the content is less than 15 wt%, fibrous swarfs are apt to occur at the dicing process, to adhere to chips, and when the content exceeds 45 wt%, the breaking of film due to heat is apt to occur at picking up of chips.

As an ethylene/acrylate-type copolymer there can be mentioned copolymers having 5 mol% or more of acrylate constituent, such as an ethylene/acrylic acid copolymer, an ethylene/methyl acrylate copolymer, an ethylene/ethyl acrylate copolymer, an ethylene/2-ethylhexyl acrylate copolymer, an ethylene/glycidyl acrylate copolymer, and an ethylene/2-hydroxyethyl acrylate copolymer; copolymers that have the acrylate of the above copolymers changed to methacrylate; a crosslinked polymer, such as ionomer; above-mentioned copolymers which, if required, may be modified by addition of or substitution by a low-molecular compound, such as maleic acid, containing a functional group, such as a carboxyl group; and a mixture formed by blending the above copolymer with a conventionally known compound.

In the above ethylene/acrylate copolymer, the breaking of film at the expanding of film or the picking up of chips becomes unlikely to occur in proportion to the order from ethylene/acrylate or ethylene/methacrylate copolymer, ethylene/acrylate ester copolymer, ethylene/methacrylate ester copolymer, to ionomer, and the content of acrylate in the copolymer is preferably from 20 to 40 wt%, but use can be made of acrylate content outside of this range.

In this embodiment, the content of ethylene/acrylate-type copolymer is limited in a range from 15 to 80 wt%, because, when the content is less than 15 wt%, the failure of picking up of chips increases due to a partial ply separation at the film expanding; and when the content exceeds 80 wt%, fibrous swarfs are apt to occur at the dicing process, to adhere to and contaminate chips, or the breaking of film due to heat is apt to occur at picking up chips. Further, other effects, such that the compatibility of styrene/ethylene/butene or pentene-type block copolymer with polyamide/polyether-type copolymer and the transmittance of radiation, both become better, can be attained by containing ethylene/acrylate-type copolymer.

Polyamide/polyether-type copolymer includes any type of copolymer, such as a graft copolymer, a block copolymer, or the like and any type of mixture form, such as an alloy of polyamide and polyether, IPN, or the like. The degree of elongation is preferably 150 wt% or more. Herein "polyamide" means a homopolyamide and a copolyamide having as a main component lactam, for example represented by polycaproamide, polyundecaneamide, and polydodecanamide, and it includes a polyetheramide and a polyesteramide which are copolymers with a monomer other than polyamide monomer. "Polyether" means a polymer of diols, such as polyethylene glycol, polypropylene glycol, polybutylene glycol, and polytetramethylene glycol. Further, the above copolymers may be modified, if required, by addition of or substitution by a low-molecular compound, such as maleic acid, containing a functional group, such as a carboxyl group, and they can be used by themselves or by mixture with a conventionally known compound.

The preferable Shore hardness D is in a range from 30 to 70.

In the resin composition, the content of polyamide/polyether-type copolymer is limited in a range from 5 to 70 wt%, because, when the content is less than 5 wt%, the breaking of film due to heat at picking up of chips is apt to occur, and when the content exceeds 70 wt%, the failure of picking up of chips increases due to a partial ply separation at the film expanding, or fibrous swarfs are apt to occur at the dicing process.

In the resin composition of the film forming the center layer of this embodiment, the content of SEBS or SEPS block copolymer is preferably 22 to 42 wt%, more preferably 27 to 42 wt%; the content of ethylene/acrylate-type copolymer is preferably 20 to 55 wt%, more preferably 20 to 35 wt%; and the content of polyamide/polyether-type copolymer is preferably 20 to 60 wt%, more preferably 30 to 60 wt%.

According to another embodiment of this invention, the center layer film comprises resin composition of the SEBS block copolymer or SEPS block copolymer: 15 to 45 wt%, amorphous poly $\alpha$-olefin: 10 to 70 wt% and polyamide/polyether-type copolymer: 20 to 70 wt%.

In this embodiment, an excellent effects can be attained wherein the fibrous swarfs are not generated at the dicing, the adhesive force high enough to secure semiconductor wafer and is reduced after irradiation of radiation with keeping a flexibility. Further other effects can be attained wherein the failure of picking up of chips is reduced because the partial ply separation is prevented and the breaking of film due to heat at the picking up, resulting chips being picked up easily and without being damaged.

The resin composition of this embodiment can be shown by the pentagon surrounded by solid lines in Fig. 2. Fig. 2 is a triangular coordinate diagram, like Fig. 1, and each vertex A, B, and C of the triangle has same meanings as in Fig. 1, except that B represents an amorphous poly a-olefin instead of the ethylene/acrylate copolymer in Fig. 1. Five points designated by H, I, J, K, and L each represent a boundary composition. That is, H represents a point of a = 15, b = 10, and c = 75 wt%, I represents a point of a = 15, b = 45, and c = 40 wt%, J represents a point of a = 35, b = 45, and c = 20 wt%, K represents a point of a = 45, b = 35, and c = 20 wt%, and L represents a point of a = 45, b = 10, and c = 45 wt%, and pentagon obtained by connecting these points successively shows the range of resin composition by its inner area.

In this embodiment, SEBS or SEPS and polyamide/polyether copolymer have the same meanings as mentioned above.

Herein "amorphous poly $\alpha$-olefin" means a polymer having a relatively low molecular weight, for example, a polymer copolymerized with propylene, ethylene, or butene-1. The above-mentioned poly $\alpha$-olefin copolymer may be modified by addition of or substitution by a low molecular compound, such as maleic acid, containing a functional group, such as a carboxyl group; and a mixture formed by blending the above copolymer with a conventionally known compound can be used. When the mixture of above-mentioned poly $\alpha$-olefin with polypropylene is used, the handleability becomes excellent since blocking is restrained; and when a modified polymer by maleic acid or the like of the above-mentioned resin the compatibility with SEBS or SEPS can be improved.

The content of amorphous poly $\alpha$-olefin is limited in a range from 10 to 45 wt%, because, when the content is less than 10 wt%, the failure of picking up of chips increases due to a partial ply separation at the film expanding; and when the content exceeds 45 wt%, the breaking of film due to heat is apt to occur at picking up chips. Further, other effects, such that the compatibility of SEBS or SEPS with polyamide/polyether-type copolymer and the transmittance of radiation, both become better, can be attained by containing amorphous $\alpha$-olefin.

In the resin composition of this embodiment, the content of SEBS or SEPS block copolymer is preferably 22 to 42 wt%, more preferably 22 to 37 wt%; the content of amorphous poly $\alpha$-olefin is preferably 10 to 30 wt%, more preferably 11 to 21 wt%; and the content of polyamide-polyether-type copolymer is preferably 25 to 65 wt%, more preferably 35 to 55 wt%.

Further, in another embodiment of this invention the center layer film comprises resin composition of SEBS or SEPS block copolymer: 15 to 45 wt%; ethylene/acrylate-type copolymer: 15 to 50 wt%; amorphous poly $\alpha$-olefin: 3 to 30 wt%; and polyamide/polyether-type copolymer: at least 20 wt%.

In this embodiment, SEBS or SEPS block copolymer, ethylene/acrylate copolymer, amorphous poly $\alpha$-olefin, and polyamide/polyether copolymer have the same meaning as mentioned in the above other embodiments.

In this embodiment, excellent effects can be attained wherein fibrous swarfs are not generated at the dicing, and the adhesive force high enough to secure the semiconductor wafer and is reduced after irradiation with radiation while flexibility is retained. Further other effects can be attained wherein the failure of picking up of chips is reduced because the partial ply separation is prevented and the breaking of film due to heat at the picking up does not occur, with the result that chips can be picked up easily and without being damaged.

In the resin composition of center layer film of this embodiment, the content of SEBS or SEPS block copolymer is preferably 16 to 30 wt%, more preferably 17 to 27 wt%; the content of ethylene/acrylate-type copolymer is preferably 20 to 45 wt%, more preferably 25 to 40 wt%; the content of amorphous poly $\alpha$-olefin is preferably 5 to 20 wt%, more preferably 5 to 15 wt%; and the content of polyamide/polyether-type copolymer is preferably 25 to 50 wt%, more preferably 25 to 40 wt%.

As the process for producing the laminated film of this invention, for example, the conventionally known co-extrusion process or laminating process is used, wherein a bonding agent may be interposed between films as customarily effected in the common production of laminated films. As the bonding agent, conventionally known bonding agents may be used such as an ethylene/vinyl acetate copolymer or a maleic acid-modified ethylene/vinyl acetate copolymer.

As the resin to be used in the present invention for the layer for adhesive coating to be applied on the side of the radiation-curable adhesive layer, for example, a resin that can transmit radiation, that hardly contaminates a semi-conductor wafer, and that is high in adhesive force to the radiation-curable adhesive, is preferred, such as ethylene resins including conventionally known ones, for example a low-density polyethylene, a straight-chain low-density polyethylene, an ethylene/vinyl acetate copolymer, an ethylene/methyl methacrylate copolymer, an ethylene/ethyl methacrylate copolymer, an ethylene/methacrylic acid copolymer, and an ethylene/acrylic acid copolymer, or mixtures of these, which will be selected arbitrarily depending upon the adhesion to the radiation-curable adhesive that will be used. This layer for adhesive coating prevents the matter that bleeds from the center layer from contaminating the semiconductor wafer as well as makes greater the adhesive force between the adhesive and the support film thereby preventing the semiconductor wafer from being contaminated by delamination of the adhesive at the time of expanding of the adhesive tape.

As the resin for the transfer-preventing layer used in the present invention, for example, ethylene resins are preferred, including conventionally known ones, for example a low-density polyethylene, a straight-chain low-density polyethylene, an ethylene/vinyl acetate copolymer, an ethylene/methyl methacrylate copolymer, an ethylene/ethyl methacrylate copolymer, an ethylene/methacrylic acid copolymer, and an ethylene/acrylic acid copolymer, or mixtures of them. This transfer-preventing layer is a layer that keep the flexibility of the adhesive tape; it prevents the support film from being blocked; and it prevents, during the storage of the support film or adhesive tape in a rolled state, the matter that bleeds from the center layer from transferring into the radiation-curable adhesive layer or the layer for adhesive coating, which transfer would eventually contaminate the semiconductor wafer.

In order to reduce the friction between the adhesive tape and a mount table at the time of expanding of the adhesive tape, and to prevent the support film from the problem of necking, the transfer-preventing layer is made of a low-density polyethylene or an ethylene/vinyl acetate copolymer, which ethylene/vinyl acetate copolymer preferably has a vinyl acetate content of up to 5 wt%. As the bonding agent for bonding the center layer to the adhesive coat layer or the transfer-preventing layer, use can be made of conventionally known bonding compounds, such as an ethylene/vinyl acetate copolymer, a maleic acid-modified ethylene/vinyl acetate copolymer, a maleic acid-modified ethylene/α-olefin copolymer, and a copolymer polyester resin, as well as mixtures of these.

The ethylene/vinyl acetate copolymer and the maleic acid-modified ethylene/vinyl acetate copolymer used as the bonding agent have preferably a vinyl acetate content of 20% or more, so that the adhesive force is high and delamination (ply separation) hardly occurs. As the process for the production of the laminated film, a known process, such as the co-extrusion process and the laminating process, is used.

Suitably the thickness of the support film is generally 30 to 300 $\mu$m, in view of the strength/elongation properties and radiation-transmitting properties desired. Although the ratio of the thickness of the center layer is set arbitrarily depending on the properties required for the support film, generally the ratio of the thickness of the center layer is preferably 30% or more, more preferably 50 to 90%, for the total thickness of the support film. If both a layer for adhesive coating layer and a transfer-preventing layer are provided, the structure of the support film becomes symmetrical, and therefore the ends of the support film will not curl, which is preferable in view of the handling.

Preferably the side of the support film opposite to the side where the radiation-curable adhesive is applied is embossed or is coated with a lubricant, because blocking can be prevented and the friction between the adhesive tape and a mount table at the time of expanding of the adhesive tape is reduced, thereby preventing necking of the support film.

As the radiation-curable adhesive, for example, a conventionally known adhesive can be used. Preferably is used an adhesive containing 100 parts by weight of an acrylic adhesive, 10 to 200 parts by weight of at least one compound selected from the group consisting of cyanurate compounds and isocyanurate compounds having a carbon-carbon double bond, and 5 to 100 parts by weight of a straight-chain polyester or polyol urethane acrylate having two carbon-carbon double bonds. The adhesive can retain the rubber-like elasticity of the adhesive layer after irradiation with radiation, so that the effect of retaining the rubber-like elasticity (flexibility) in the adhesive tape after irradiation with radiation is particularly high.

When the semiconductor wafer-securing adhesive tape of the present invention is cured by irradiation with ultraviolet rays, if a photopolymerization initiator, such as isopropyl benzoin ether, isobutyl benzoin ether, benzophenone, Michler's ketone, chlorothioxanthone, dodecylthioxanthone, dimethylthioxanthone, diethylthioxanthone, benzyldimethylketal, α-hydroxycyclohexyl phenyl ketone, and 2-hydroxymethylphenylpropane, is added, the cure reaction can be allowed to efficiently proceed to lower the adhesive force for securing the chips, even if the cure reaction time is short or the amount of irradiation with ultraviolet rays is small. If necessary, a radiation-curable silicon acrylate or silicon methacrylate may be added, in order to lower favorably the adhesive force for securing chips after irradiation with radiation; or, for example, a sequestering agent, a tackifier, an adhesion adjuster, a surface-active agent, other modifier, and conventional components, can similarly be added to the specifically treated surface coated with a metal substance on the surface of the semiconductor wafer, which metal substance is an adhered, for example, so as to lower the adhesive force for securing chips. The thickness of this radiation-curable adhesive layer is generally 2 to 50 $\mu$m.

When the present semiconductor-securing adhesive tape is used in cutting a semiconductor wafer or the like, the adhesive tape has a chip-securing adhesive force high enough to secure chips without allowing chips to come off or to be displaced when the wafer is cut into chips by a rotating circular blade, and further since the support film is good in transmission of radiation, after the irradiation with radiation the adhesive takes a three-dimensional structure and the chip securing adhesive force can be lowered when the chips are picked up. Further, since the adhesive tape retains the flexibility and is excellent in expandability after the irradiation with radiation, the tape allows intervals between chips to be enlarged sufficiently and uniformly.

Therefore, there is an excellent effect that the chips can be picked up easily without being damaged. Since the support film does not contain a chlorine-containing compound, which would harmfully affect semiconductor wafer, a metal-compound-type stabilizer, and a plasticizer, or the like, which will contaminate

8

a semiconductor wafer, semiconductor chips will not be contaminated with the radiation-curable adhesive, so that an excellent effect is exhibited in that the yield of the chips is increased.

Further, excellent effects can be attained wherein fibrous swarfs are not generated at the dicing, and the adhesive force is high enough to secure semiconductor wafer and is reduced after irradiation with radiation while flexibility is retained. Further, other effects can be attained wherein the failure of picking up of chips is reduced because the partial ply separation is prevented and the breaking of film due to heat at the picking up does not occur, with the result that chips can be picked up easily and without being damaged.

Now the present invention will be described with reference to Examples, but the invention is not limited to them.

In the Examples, properties were tested and evaluated as follows:

(1) Adhesive force (g/25 mm)

The adhesive force is an index for checking the extent of the adhesive force for securing chips before and after the irradiation.

An Si wafer having a diameter of 5 inches was caused to adhere to the prepared radiation-curable adhesive tape, and the adhesive force before and after irradiation with ultraviolet rays was measured in accordance with JIS Z-0237 (peeling: at 90°C, and peeling strength: at 50 mm/min). Herein, the surface of the wafer to be attached to the adhesive tape was made in two states, i.e. in the states of the planished surface and #600 surface finished by lapping (the surface had very fine grains corresponding to US mesh #600). The adhesive force was evaluated as follows.

Before irradiation with UV:   good: ≥ 120 (g/25 mm)
                             defective: < 120 (g/25 mm)
After irradiation with UV:    good: ≤ 30 (g/25 mm)
                              defective: > 30 (g/25 mm)

(2) Intervals between chips (μm)

The intervals between chips is an index for checking the extent and uniformity of the intervals between chips in longitudinal/transverse directions at the time of expanding of the adhesive tape.

A wafer was cut fully into chips of size 3 mm x 3 mm then after the tape was cured with ultraviolet rays, the tape was stretched by a wafer-expansion apparatus (air pressure: 2.0 kg/cm$^2$), and the amount of the intervals between the chips in the longitudinal/transverse directions was measured, to find the extent and uniformity of the intervals between the chips. The amount of the intervals between the chips included 40 μm which was the thickness of the blade used in dicing.

The extent of the intervals between the chips (q):
   q ≥ 200 μm:          the image of the chips can be well recognized.
   200 > q ≥ 100 μm:    the image of the chips can be recognized.
   100 > q ≥ 80 μm:     the image of the chips is difficult to recognize.
   q < 80 μm:           the image of the chips is impossible to recognize.
The uniformity:
   longitudinal/transverse directions ≤ 1.5:    good
   longitudinal/transverse directions > 1.5:    defective

(3) Contamination of a Si wafer

The contamination of an Si wafer is an index for checking the extent of contamination of a semiconductor wafer with the radiation-curable adhesive (the adhesion between the radiation-curable adhesive and the support film), and also an index for checking the extent of the presence of compounds that influence harmfully or contaminate the semiconductor wafer.

An Si wafer was secured to a support film that used an acrylic adhesive whose initial adhesive strength to the wafer was 300 to 350 g/width of 25 mm, and whose cured adhesive strength to the wafer was 10 to 15 g/width of 25 mm and which had been rolled and stored, at 40°C, the contamination of the Si wafer was evaluated according to the following criteria. Only one "≥ 4 W" is acceptable.

   ≥ 4W:    not contaminated even after 4 weeks
   3W:      not contaminated for 3 weeks
   2W:      not contaminated for 2 weeks
   1W:      not contaminated for 1 week

< 1W:   contaminated before 1 week

(4) The state at the time when the adhesive tape was expanded at a stroke of 30 mm

O:   not broken
X:   broken

Examples 1 to 7 and Comparative Examples 1 to 3

Support films having the layer constitutions shown in Table 1 were prepared by co-extruding single resins or kneaded blend compositions through an extruder. The thickness of all the support films was 100 μm. The surface of each of the obtained support films on the side where the adhesive coat was applied was subjected to corona treatment, and an adhesive was coated thereon so that the thickness of the adhesive layer after being dried might be 10 μm, thereby preparing each radiation-curable adhesive tape. The physical properties of the adhesive tape were tested as described above and the results are shown in Table 1.

The compounds used in the Examples and Comparative Examples are given below.

Where the materials used for the center layer of the adhesive tape had a molecular weight of 90,000 or over and were used alone, they could not be formed into a film, so they could not be evaluated.

Material A (SEBS):

KRATON G-1650, SEBS block-type copolymer manufactured by Shell Chemical Company.
styrene: 29%; molecular weight: 70,000

Material B (SEBS):

KRATON G-1657X, SEBS block-type copolymer, manufactured by Shell Chemical Company.
styrene: 13%; molecular weight: 80,000

Material C (maleic acid-modified SEBS):

TUFTEC M 1943, manufactured by Asahi Chemical Industry Co., Ltd.
styrene: 20%; molecular weight: 50,000

Material D (SEBS):

TUFTEC H 1041, SEBS block-type copolymer, manufactured by Asahi Chemical Industry Co., Ltd.
styrene: 30%; molecular weight: 50,000

Material E (SEBS):

TUFTEC H 1031, SEBS block-type copolymer, manufactured by Asahi Chemical Industry Co., Ltd.
styrene: 20%; molecular weight: 30,000

Material F (SEBS):

TUFTEC H 1051, SEBS block-type copolymer, manufactured by Asahi Chemical Industry Co., Ltd.
styrene: 40%; molecular weight: 50,000

Material G (a blend of SEBS block-type copolymer, having a molecular weight of 10,000 or more and a styrene content of 30% with EPDM):

RABALON ME 5302 C, manufactured by Mitsubishi Petrochemical Co., Ltd.

Adhesive A:

| Acrylic adhesive | 100 pts. wt. |
|---|---|
| Isocyanurate compound | 80 pts. wt. |
| Urethaneacrylate compound | 20 pts. wt. |
| Photopolymerization initiator | 1 pt. wt. |

Adhesive B:

| Acrylic adhesive | 100 pts. wt. |
|---|---|
| Cyanurate compound | 40 pts. wt. |
| Urethaneacrylate compound | 10 pts. wt. |

Adhesive C:

| Acrylic adhesive | 100 pts. wt. |
|---|---|
| Isocyanurate compound | 80 pts. wt. |
| Photopolymerization initiator | 1 pt. wt. |

EVA-15 (an ethylene/vinyl acetate copolymer having a vinyl content of 10%):
    EVATATE H 2021 F, manufactured by Sumitomo Chemical Co., Ltd.
EVA-3 (an ethylene/vinyl acetate copolymer having a vinyl content of 3%):
    MITSUBISHI POLYETHY-EVA V 113 K, manufactured by Mitsubishi Petrochemical Co., Ltd.

## Table 1

| | This Invention | | | | | | | Comparison | | |
|---|---|---|---|---|---|---|---|---|---|---|
| | 1 | 2 | 3 | 4 | 5 | 6 | 7 | 1 | 2 | 3 |
| **Support Film Constituent** | | | | | | | | | | |
| Curable Adhesive Layer (10 μm) | Adhesive A | A | A | A | A | A | B | A | A | A |
| Layer for Adhesive coating (10 μm) | EVA-15 | EVA-15 | EVA-15 | EVA-15 | EVA-15 | LLDPE | EVA-15 | EVA-15 | EVA-15 | EVA-15 |
| Center layer (80 μm) | Material A | B | C | D | A&EPR[4] | A | A | E | F | G |
| Tranfer-preventig Layer (10 μm) | EVA-3 | EVA-3 | EVA-3 | EVA-3 | EVA-3 | LLDPE | EVA-3 | EVA-3 | EVA-3 | EVA-3 |
| **Adhesive Force (g/25mm)** | | | | | | | | | | |
| Mirror   Before Irradiation | 280 | 280 | 280 | 280 | 280 | 200 | 150 | 280 | 280 | 260 |
|      After Irradiation | 14 | 14 | 14 | 14 | 15 | 12 | 15 | 14 | 28 | 14-30[2] |
| #600   Before Irradiation | 320 | 320 | 320 | 320 | 320 | 220 | 180 | 320 | 320 | 300 |
|      After Irradiation | 20 | 20 | 20 | 20 | 21 | 16 | 26 | 20 | 40 | 22-38[3] |
| **Intervals between Chips [1]** | | | | | | | | | | |
| Extent (μm) | 230 | 310 | 280 | 220 | 150 | 220 | 230 | 280 | 90 | 220 |
| Uniformity | 1.4 / -1.5 | 1.4 / -1.5 | 1.2 / -1.3 | 1.4 / -1.5 | 1.3 / -1.4 | 1.4 / -1.5 | 1.4 / -1.5 | 1.4 / -1.5 | 1.4 / -1.5 | 1.4 / -1.5 |
| Contamination | ≧4W | ≧4W | ≧4W | ≧4W | ≧4W | ≧4W | ≧4W | ≧4W | 1W | <1W |
| Expanded State at a Stroke 30 mm | ○ | ○ | ○ | ○ | ○ | ○ | ○ | × | ○ | ○ |

Note;
1) Expand stroke was 10 mm.
2) The values of adhesion force varied.
3) The values of adhesion force varied.
4) A blend of A and EPR of 50:50 in weight ratio

As is apparent from the results in Table 1, in Examples of this invention, a semiconductor wafer-securing adhesive tape is obtained wherein the adhesive force is good both before and after irradiation with radiation, the interval between chips after expanding is large enough and uniform, and the contamination of wafer by adhesive is acceptably small. On the contrary, in Comparative Examples, there are found breaking of film (Comparison 1), not enough lowering of adhesive force after irradiation with radiation, less interval

12

between chips and contamination by adhesive (Comparison 2), and adhesive force having scattering results and contamination by adhesive (Comparison 3).

Example 8 and Comparative Examples 4 and 5

Radiation-curable tapes were prepared in the same manner as Example 1, except that support films having the layer constitutions shown in Table 2 were used. The physical properties of each of the tapes were tested in the same manner as in Example 1 and the results are shown in Table 2.

The compounds used in the Example and Comparative Examples were as follows:

Material H:

SEPTON 2043, SEPS block-type copolymer, manufactured by Kuraray Co., Ltd.
styrene: 13%; molecular weight: about 200,000

Material I (SEPS):

SEPTON 2063, SEPS block-type copolymer, manufactured by Kuraray Co., Ltd.
styrene: 13%; molecular weight: about 100,000

Material J (SEPS):

SEPTON 2103, SEPS block-type copolymer, manufactured by Kuraray Co., Ltd.
styrene: 50%; molecular weight: about 200,000

Adhesive A:

| | |
|---|---|
| Acrylic type adhesive | 100 pts. wt. |
| Isocyanurate compound | 80 pts. wt. |
| Urethaneacrylate compound | 20 pts. wt. |
| Photopolymerization initiator | 1 pt. wt. |

EVA-10 (ethylene/vinyl acetate copolymer having a vinyl acetate content of 10%):
EVATATE H 2021 F, manufactured by Sumitomo Chemical Co., Ltd.
EVA-3 (ethylene/vinyl acetate copolymer having a vinyl acetate content of 3%):
MITSUBISHI POLYETHY-EVA in 113 K, manufactured by Mitsubishi Petrochemical Co., Ltd.

Table 2

| | | This Invention | Comparison | |
|---|---|---|---|---|
| | | 8 | 4 | 5 |
| Support Film Constituent | | | | |
| Curable Adhesive Layer (10μm) | | Adhesive A | A | A |
| Layer for Adhesive Coating (10μm) | | EVA-10 | EVA-10 | EVA-10 |
| Center layer (80 μm) | | Material D | E | F |
| Transfer-preventig Layer (10μm) | | EVA-3 | EVA-3 | EVA-3 |
| Adhesive Force (g/25mm) | | | | |
| Mirror | Before Irradiation<br>After Irradiation | 280<br>14 | 280<br>14 | 280<br>32 |
| # 600 | Before Irradiation<br>After Irradiation | 320<br>20 | 320<br>20 | 320<br>44 |
| Intervals between Chips | | | | |
| Extent (μm) | | 240 | 290 | 90 |
| Uniformity | | 1.4-1.5 | 1.4-1.5 | 1.4-1.5 |
| Contamination | | ≧4W | ≧4W | 1W |
| Expanded State at a Stroke 30 mm | | ○ | X | ○ |

As is apparent from the results of Table 2, the semiconductor wafer-securing adhesive tape of Example 8 of this invention shows the same good properties as Examples 1 to 7 in Table 1, but in Comparative Examples 4 and 5, the breaking of film, not enough enlarging of the interval between chips and contamination by adhesive are found.

Examples 9 to 13 and Comparative Examples 6 to 8

Radiation-curable adhesive tapes were prepared in the same manner as Example 1, except that support films having the layer constitutions as shown in Table 3 were used. The physical properties of each of the tapes were tested in the same manner as in Example 1, except that strength at picking up, ply separation, and failure ratio of picking up were tested, and the results are shown in Table 3.

The compounds used in the Examples and Comparative Examples are given below.

Resin I (SEBS):

KRATON G-1675X, SEBS block-type copolymer, manufactured by Shell Chemical Company.
styrene: 13%; molecular weight: 80,000

Resin II (Styrene/ethyl acrylate copolymer)

PRIMACOL 5980, manufactured by Dow Chemicals.

Resin III (Polyamide/polyether copolymer):

ELY 2742, manufactured by EMS JAPAN CORPORATION.
EVA-10: The same as EVA-10 in Example 8
EVA-3: The same as EVA-3 in Example 1
In the Examples, properties were tested and evaluated as follows:

14

(1) Adhesive force (g/25 mm):

The same test and evaluation as in Example 1 were conducted.

(2) Intervals between chips ($\mu$m):

The same test and evaluation as in Example 1 were conducted.

(3) The state at the time when the adhesive tape was expanded at a stroke of 30 mm:

The same test and evaluation as in Example 1 were conducted.

(4) Fraction of defective chips (Contamination of an Si wafer):

The number of chips with adherence of swarf of 100 $\mu$m or more of length were recorded. A number less than 5 in 10,000 chips picked up is acceptable.

(5) The state at the time when chips were picked up:

O:        not broken
X:        broken

(6) Ply separation:

O:        not separated
X:        separated

(7) Failure of picking up of chips

The number of picking up failures was recorded. A number less than 5 per 5 wafers of 5 inches (10,000 chips) is acceptable. This ratio becomes large when the image identification is difficult due to small intervals between chips or when chips do not release from support film due to a ply separation.

Table 3

| | This Invention | | | | | Comparison | | |
|---|---|---|---|---|---|---|---|---|
| | 9 | 10 | 11 | 12 | 13 | 6 | 7 | 8 |
| Support Film Constituent | Adhesive A | | | | | | | |
| Curable Adhesive Layer (10μm) | A | A | A | A | A | A | A | A |
| Layer for Adhesive Coating(1μm) | EVA-10 | EVA-10 | EVA-10 | EVA-10 | EVA-10 | EVA-10 | EVA-10 | EVA-10 |
| Center layer (80μm) | | | | | | | | |
| Material I (%) | 20 | 20 | 30 | 40 | 40 | 0 | 0 | 60 |
| Material II (%) | 20 | 70 | 40 | 20 | 50 | 0 | 100 | 25 |
| Material III (%) | 60 | 10 | 30 | 40 | 10 | 100 | 0 | 15 |
| Transfer-preventing Layer(10μm) | EVA-3 | EVA-3 | EVA-3 | EVA-3 | EVA-3 | EVA-3 | EVA-3 | EVA-3 |
| Adhesive Force (g/25mm) | | | | | | | | |
| Before Irradiation | 280 | 280 | 280 | 280 | 280 | 280 | 280 | 280 |
| After Irradiation | 18 | 15 | 17 | 18 | 16 | 14 | 14 | 18 |
| Intervals between Chips | | | | | | | | |
| Extent (μm) 3mm x 3mm | 160 | 160 | 170 | 180 | 180 | 150 | 80 | 210 |
| 6mm x 6mm | 230 | 230 | 250 | 280 | 280 | 210 | 120 | 300 |
| Uniformity | 1.3-1.4 | 1.3-1.4 | 1.3-1.4 | 1.3-1.4 | 1.3-1.4 | 1.4-1.5 | 1.4-1.5 | 1.3-1.4 |
| Strength at Expanding of film | O | O | O | O | O | O | × | O |
| Strength at Picking up of Chips | O | O | O | O | O | O | O | O |
| Ply Separation | O | O | O | O | O | × | O | × |
| Failure of Picking up of Chips | 4 | 1 | 2 | 2 | 0 | 6 | 0 | 0 |
| Fraction of defective Chips | 4 | 4 | 3 | 3 | 3 | 6 | 6 | 2 |

As is apparent from the results in Table 3, in Examples of this invention, a semiconductor wafer-securing adhesive tape is obtained wherein both adhesive forces before and after irradiation of radiation are good, the interval between chips after expanding is large enough and uniform, film strengths both at expanding and at picking up of chips, and interlaminer strength, are all good (no breaking and no ply separation), and failure ratio of picking up and fraction of defective chips both are acceptably small. On the contrary, in Comparative Examples, there are found the breaking of film and not enough enlarging of the interval between chips, and the failure ratio of picking up and the fraction of defective chips are not so good.

Examples 14 to 18 and Comparative Examples 9 to 12

Radiation-curable adhesive tapes were prepared in the same manner as Example 9, except that support films having the layer constitutions shown in Table 4 were used. The physical properties of each of the tapes were tested in the same manner as in Example 9 and the results are shown in Table 4.

The compounds used in the Examples and Comparative Examples are the same as those in Example 9, except that resin II was changed as given below.

Resin II (amorphous poly $\alpha$-olefin):

APAO RT 2780, manufactured by UBE-LEXENE.

Table 4

|  | | This Invention | | | | | Comparison | | | |
|---|---|---|---|---|---|---|---|---|---|---|
|  | | 14 | 15 | 16 | 17 | 18 | 9 | 10 | 11 | 12 |
| Support Film Constituent | | | | | | | | | | |
| Curable Adhesive Layer (10 μm) | Adhesive A | | | | | | | | | |
| Layer for Adhesive Coating (m) | | EVA-10 | EVA-10 | EVA-10 | EVA-10 | EVA-10 | EVA-10 | EVA-10 | EVA-10 | EVA-10 |
| Center layer (80 μm) | | | | | | | | | | |
| Material I | (%) | 20 | 20 | 30 | 35 | 40 | 0 | 20 | 45 | 60 |
| Material II | (%) | 20 | 40 | 25 | 35 | 20 | 0 | 60 | 45 | 20 |
| Material III | (%) | 60 | 40 | 45 | 30 | 40 | 100 | 20 | 10 | 20 |
| Transfer-preventing Layer (10 μm) | EVA-3 | EVA-3 | EVA-3 | EVA-3 | EVA-3 | EVA-3 | EVA-3 | EVA-3 | EVA-3 | EVA-3 |
| Adhesive Force (g/25mm) | | | | | | | | | | |
| Before Irradiation | | 280 | 280 | 280 | 280 | 280 | 280 | 280 | 280 | 280 |
| After Irradiation | | 18 | 16 | 18 | 16 | 18 | 14 | 15 | 16 | 18 |
| Intervals between Chips | | | | | | | | | | |
| Extent (μm) 3mm x 3mm | | 160 | 160 | 170 | 170 | 180 | 150 | 160 | 190 | 210 |
| 6mm x 6mm | | 230 | 230 | 250 | 250 | 280 | 210 | 230 | 290 | 300 |
| Uniformity | | 1.3-1.4 | 1.3-1.4 | 1.3-1.4 | 1.3-1.4 | 1.3-1.4 | 1.4-1.5 | 1.3-1.4 | 1.3-1.4 | 1.3-1.4 |
| Strength at Expanding | | O | O | O | O | O | O | × | O | O |
| Strength at Picking up of Chips | | O | O | O | O | O | O | O | × | × |
| Ply Separation | | O | O | O | O | O | × | O | O | O |
| Failure of Picking up of chips | | 4 | 3 | 3 | 2 | 2 | 6 | 2 | 1 | 0 |
| Fraction of defective Chips | | 4 | 4 | 3 | 3 | 3 | 6 | 4 | 3 | 2 |

18

As is apparent from the results in Table 4, the semiconductor wafer-securing adhesive tapes of Examples of this invention show good properties, but, in Comparative Examples, there are found breaking of film and partial ply separation.

Examples 19 to 21

Radiation-curable adhesive tapes were prepared in the same manner as Example 9, except that support films having the layer constitutions shown in Table 5 were used. The physical properties of each of the tapes were tested in the same manner as in Example 9 and the results are shown in Table 5.

## EP 0 520 515 B1

Table 5

| | | This Invention | | |
|---|---|---|---|---|
| | | 19 | 20 | 21 |
| Support Film Constituent | | | | |
| Curable Adhesive Layer (10μm) | | Adhesive A | A | A |
| Layer for Adhesive Coating(1μm) | | EVA-10 | EVA-10 | EVA-10 |
| Center layer (80μm) | | | | |
| Material I (%) | | 30 | 30 | 30 |
| Material II (%) | | 31 | 20 | 4 |
| Material III (%) | | 3 | 12 | 22 |
| Material IV (%) | | 36 | 38 | 44 |
| Transfer-preventing Layer(10μm) | | EVA-3 | EVA-3 | EVA-3 |
| Adhesive Force (g/25mm) | | | | |
| Before Irradiation | | 280 | 280 | 280 |
| After Irradiation | | 17 | 17 | 18 |
| Intervals between Chips | | | | |
| Extent (μm) | 3 x 3 mm<br>6 x 6 mm | 170<br>250 | 170<br>250 | 170<br>250 |
| Uniformity | | 1.3-1.4 | 1.3-1.3 | 1.3-1.4 |
| Expanded State at a Stroke 30mm | | ○ | ○ | ○ |
| State at Picking up of Chips | | ○ | ○ | ○ |
| Ply Separation | | ○ | ○ | ○ |
| Failure of Picking up of Chips | | 2 | 2 | 3 |
| Fraction of Defective Chips | | 3 | 3 | 3 |
| Note;<br>Material I : SEBS Block-type Copolymer<br>Material II : Ethylene/Acrylic Acid Copolymer<br>Material III : Amorphous Poly α-Olefin<br>Material IV : Polyamide/Polyether Copolymer | | | | |

As is apparent from the results in Table 5, in Examples of this invention, a semiconductor wafer-securing adhesive tape having excellent properties is obtained.

Having described our invention as related to the present embodiments, it is our intention that the invention not be limited by any of the details of the description, unless otherwise specified, but rather be construed broadly within its spirit and scope as set out in the accompanying claims.

## Claims

1.  A semiconductor wafer-securing adhesive tape having a radiation-curable adhesive layer on one surface of a support film, wherein the support film is composed of a laminated film that comprises, as a center layer, a film comprising a styrene/ethylene/butene/styrene block-type copolymer having a styrene polymer block component (A) and an ethylene/butene copolymer block component (B), with the component (A) being 10 to 30 wt% of components (A) + (B), and having a weight-average molecular weight of 35,000 to 90,000; and has a layer for adhesive coating laid, directly or through a bonding

20

layer, on one surface of the center layer on the side where said radiation-curable adhesive layer is provided and has a transfer-preventing layer laid on the other surface of the center layer.

2. A semiconductor wafer-securing adhesive tape having a radiation-curable adhesive layer on one surface of a support film, wherein the support film is composed of a laminated film that comprises, as a center layer, a film comprising a styrene/ethylene/pentene/styrene block-type copolymer having a styrene polymer block component (A) and an ethylene/pentene copolymer block component (C) with the component (A) being 10 to 30 wt% of components (A) + (C), and having a weight-average molecular weight of 150,000 to 500,000, and has a layer for adhesive coating laid, directly or through a bonding layer, on one surface of the center layer on the side where said radiation-curable adhesive layer is provided and has a transfer-preventing layer laid on the other surface of the center layer.

3. The semiconductor wafer-securing adhesive tape as claimed in claim 1, wherein the center layer is a film consisting essentially of said styrene/ethylene/butene/styrene block-type copolymer.

4. The semiconductor wafer-securing adhesive tape as claimed in claim 2, wherein the center layer is a film consisting essentially of said styrene/ethylene/pentene/styrene block-type copolymer.

5. The semiconductor wafer-securing adhesive tape as claimed in claim 1, wherein the center layer is a film that comprises said styrene/ethylene/butene/styrene block-type copolymer: 15 to 45 wt%, ethylene/acrylate-type copolymer: 15 to 80 wt%, and polyamide/polyether-type copolymer: 5 to 70 wt%.

6. The semiconductor wafer-securing adhesive tape as claimed in claim 2, wherein the center layer is a film that comprises said styrene/ethylene/pentene/styrene block-type copolymer: 15 to 45 wt%, ethylene/acrylate-type copolymer: 15 to 80 wt%, and polyamide/polyether-type copolymer: 5 to 70 wt%.

7. The semiconductor wafer-securing adhesive tape as claimed in claim 1, wherein the center layer is a film that comprises said styrene/ethylene/butene/styrene block-type copolymer: 15 to 45 wt%, amorphous poly α-olefin: 10 to 45 wt%, and polyamide/polyether-type copolymer: 20 to 70 wt%,

8. The semiconductor wafer-securing adhesive tape as claimed in claim 2, wherein the center layer is a film that comprises said styrene/ethylene/pentene/styrene block-type copolymer: 15 to 45 wt%, amorphous poly α-olefin: 10 to 45 wt%, and polyamide/polyether-type copolymer: 20 to 70 wt%.

9. The semiconductor wafer-securing adhesive tape as claimed in claim 1, wherein the center layer is a film that comprises said styrene/ethylene/butene/styrene block-type copolymer: 15 to 45 wt%, ethylene/acrylate-type copolymer: 15 to 50 wt%, amorphous poly α-olefin: 3 to 30 wt%, and polyamide/polyether-type copolymer: at least 20 wt%.

10. The semiconductor wafer-securing adhesive tape as claimed in claim 2, wherein the center layer is a film that comprises said styrene/ethylene/pentene/styrene block-type copolymer: 15 to 45 wt%, ethylene/acrylate-type copolymer: 15 to 50 wt%, amorphous poly α-olefin: 3 to 30 wt%, and polyamide/polyether-type copolymer: at least 20 wt%.

**Patentansprüche**

1. Klebeband zum Befestigen von Halbleiterplättchen mit
   - einer strahlungshärtbaren Klebeschicht auf einer Fläche eines Trägerfilms, wobei sich der Trägerfilm aus einem Schichtfilm aufbaut, der als Mittelschicht einen Film mit einem Styrol/Ethylen/Buten/Styrol-Mischpolymeren vom Blocktyp mit einer Styrolpolymerblockkomponente (A) und mit einer Ethylen/Bu-ten-Mischpolymerblockkompente (B) umfaßt, wobei die Komponente (A) 10 - 30 Gew.-% der Komponenten (A) + (B) ausmacht und mit einem Gewichtsmittel des Molekulargewichts von 35.000 bis 90.000; und mit
   - einer klebenden Beschichtungsschicht direkt oder mittels einer Bindungsschicht auf einer Fläche der Mittelschicht auf der Seite, auf der die strahlungshärtbare Klebeschicht vorgesehen ist, und mit
   - einer Übertragungshemmschicht auf der anderen Seite der Mittelschicht.

2. Klebeband zum Befestigen von Halbleiterplättchen mit

   - einer strahlungshärtbaren Klebeschicht auf einer Seite eines Trägerfilms, wobei der Trägerfilm aus einem Schichtfilm aufgebaut ist, der als Mittelschicht einen Film mit einem Styrol/Ethylen/Penten/Styrol-Mischpolymeren vom Blocktyp mit einer Styrolpolymerblockkomponente (A) und einer Ethylen/Penten-Mischpolymerblockkomponente (C) umfaßt, wobei die Komponente (A) 10 bis 30 Gew.-% der Komponenten (A) + (C) ausmacht und mit einem Gewichtsmittel des Molekulargewichts von 150.000 bis 500.000, und mit
   - einer Schicht zum Klebebeschichten direkt oder mittels einer Bindungsschicht auf einer Fläche der Mittelschicht auf der Seite, auf der die strahlungshärtbare Klebemittelschicht vorgesehen ist, und mit
   - einer Übertragungshemmschicht auf der anderen Seite der Mittelschicht.

3. Klebeband zum Befestigen von Halbleiterplättchen nach Anspruch 1, wobei die Mittelschicht ein Film aus im wesentlichen einem Styrol/Ethylen/Buten/Styrol-Mischpolymeren vom Blocktyp ist.

4. Klebeband zum Befestigen von Halbleiterplättchen nach Anspruch 2, wobei die Mittelschicht ein Film aus im wesentlichen einem Styrol/Ethylen/Penten/Styrol-Mischpolymeren vom Blocktyp ist.

5. Klebeband zum Befestigen von Halbleiterplättchen nach Anspruch 1, wobei die Mittelschicht ein Film ist, der ein Styrol/Ethylen/Buten/Styrol-Mischpolymeres vom Blocktyp (15 bis 45 Gew.-%), ein Ethylen/Acrylat-Mischpolymeres (15 bis 80 Gew.-%) und ein Polyamid/Polyether-Mischpolymeres (5 bis 70 Gew.-%) umfaßt.

6. Klebeband zum Befestigen von Halbleiterplättchen nach Anspruch 2, wobei die Mittelschicht ein Film ist, der ein Styrol/Ethylen/Penten/Styrol-Mischpolymeres vom Blocktyp (15 bis 45 Gew.-%), ein Ethylen/Acrylat-Mischpolymeres (15 bis 80 Gew.-%) und ein Polyamid/Polyether-Mischpolymeres (5 bis 70 Gew.-%) umfaßt.

7. Klebeband zum Befestigen von Halbleiterplättchen nach Anspruch 1, wobei die Mittelschicht ein Film ist, der ein Styrol/Ethylen/Buten/Styrol-Mischpolymeres vom Blocktyp (15 bis 45 Gew.-%), ein armorphes Poly-α-olefin (10 bis 45 Gew.-%) und ein Polyamid/Polyether-Mischpolymeres (20 bis 70 Gew.-%) umfaßt.

8. Klebeband zum Befestigen von Halbleiterplättchen nach Anspruch 2, wobei die Mittelschicht ein Film ist, der ein Styrol/Ethylen/Penten/Styrol-Mischpolymeres vom Blocktyp (15 bis 45 Gew.-%), ein armorphes Poly-α-olefin (10 bis 45 Gew.-%) und ein Polyamid/Polyether-Mischpolymeres (20 bis 70 Gew.-%) umfaßt.

9. Klebeband zum Befestigen von Halbleiterplättchen nach Anspruch 1, wobei die Mittelschicht ein Film ist, der ein Styrol/Ethylen/Buten/Styrol-Mischpolymeres vom Blocktyp (15 bis 45 Gew.-%), ein Ethylen/Acrylat-Mischpolymeres (15 bis 50 Gew.-%), ein armorphes Poly-α-olefin (3 bis 30 Gew.-%) und ein Polyamid/Polyether-Mischpolymeres (mindestens 20 Gew.-%) umfaßt.

10. Klebeband zum Befestigen von Halbleiterplättchen nach Anspruch 2, wobei die Mittelschicht ein Film ist, der ein Styrol/Ethylen/Penten/Styrol-Mischpolymeres vom Blocktyp (15 bis 45 Gew.-%), ein Ethylen/Acrylat-Mischpolymeres (15 bis 50 Gew.-%), ein armorphes Poly-α-olefin (3 bis 30 Gew.-%) und ein Polyamid/Polyether-Mischpolymeres (mindestens 20 Gew.-%) umfaßt.

**Revendications**

1. Ruban adhésif pour la fixation de pastilles semi-conductrices comportant une couche adhésive durcissable aux rayonnements, formée sur une première surface d'un film de support, dans lequel le film de support est composé d'un film stratifié qui comporte, en tant que couche centrale, un film comprenant d'un copolymère du type séquencé styrène/éthylène/butène/styrène contenant un polymère de styrène en tant que constituant séquentiel (A) et un copolymère éthylène/butène en tant que constituant séquentiel (B), le constituant (A) représentant 10 à 30% en poids des constituants (A) + (B), et ayant un poids moléculaire moyen compris entre 35 000 et 90 000; et comporte une couche d'enduction d'adhésif qui est déposée directement, ou via une couche de liant, sur une première surface de la couche centrale du côté ou la couche adhésive durcissable aux rayonnements est agencée et comporte une couche anti-transfert qui est déposée sur l'autre surface de la couche centrale.

2. Ruban adhésif pour la fixation de pastilles semi-conductrices comportant une couche adhésive durcissable aux rayonnements formée sur une première surface d'un film de support, dans lequel le film de support est comprenant d'un film stratifié qui comporte, en tant que couche centrale, un film constitué d'un copolymère du type séquencé styrène/éthylène/pentène/styrène contenant un polymère de styrène en tant que constituant séquentiel (A) et un copolymère éthylène/pentène en tant que constituant séquentiel (C), le constituant (A) représentant 10 à 30% en poids des constituants (A) + (C), et ayant un poids moléculaire moyen compris entre 150 000 et 500 000; et comporte une couche d'enduction d'adhésif qui est déposée directement, ou via une couche de liant, sur une première surface de la couche centrale du côté où ladite couche adhésive durcissable aux rayonnements est agencée et comporte une couche anti-transfert formée sur l'autre surface de la couche centrale.

3. Ruban adhésif pour la fixation de pastilles semi-conductrices selon la revendication 1, dans lequel la couche centrale est un film constitué essentiellement dudit copolymère du type séquencé styrène/éthylène/butène /styrène.

4. Ruban adhésif pour la fixation de pastilles semi-conductrices selon la revendication 2, dans lequel la couche centrale est un film constitué essentiellement dudit copolymère du type séquencé styrène/éthylène /pentène/styrène.

5. Ruban adhésif pour la fixation de pastilles semi-conductrices selon la revendication 1, dans lequel la couche centrale est un film qui est comprenant dudit copolymère du type séquencé styrène/éthylène/butène /styrène : en proportion de 15 à 45% en poids, du copolymère du type éthylène/acrylate : en proportion de 15 à 80% en poids, et du copolymère du type polyamide/polyéther : en proportion de 5 à 70% en poids.

6. Ruban adhésif pour la fixation de pastilles semi-conductrices selon la revendication 2, dans lequel la couche centrale est un film qui est comprenant dudit copolymère du type séquencé styrène/éthylène/pentène /styrène : en proportion de 15 à 45% en poids, du copolymère du type éthylène/acrylate : en proportion de 15 à 80% en poids, et du copolymère du type polyamide/polyéther : en proportion de 5 à 70% en poids.

7. Ruban adhésif pour la fixation de pastilles semi-conductrices selon la revendication 1, dans lequel la couche centrale est un film qui est comprenant dudit copolymère du type séquencé styrène/éthylène/butène /styrène : en proportion de 15 à 45% en poids, de poly $\alpha$-oléfine amorphe: en proportion de 10 à 45 % en poids, et du copolymère du type polyamide/polyéther : en proportion de 20 à 70% en poids.

8. Ruban adhésif pour la fixation de pastilles semi-conductrices selon la revendication 2, dans lequel la couche centrale est un film qui est comprenant dudit copolymère du type séquencé styrène/éthylène /pentène/styrène : en proportion de 15 à 45% en poids, de poly $\alpha$-oléfine amorphe : en proportion de 10 à 45% en poids, et du copolymère du type polyamide/polyéther : en proportion de 20 à 70% en poids.

9. Ruban adhésif pour la fixation de pastilles semi-conductrices selon la revendication 1, dans lequel la couche centrale est un film qui est comprenant dudit copolymère du type séquencé styrène/éthylène/butène /styrène : en proportion de 15 à 45% en poids, du copolymère du type éthylène/acrylate : en proportion de 15 à 50% en poids, de poly $\alpha$-oléfine amorphe : en proportion de 3 à 30% en poids, et du copolymère du type polyamide/polyéther : au moins 20% en poids.

10. Ruban adhésif pour la fixation de pastilles semi-conductrices selon la revendication 2, dans lequel la couche centrale est un film qui est comprenant dudit copolymère du type séquencé styrène/éthylène /pentène/styrène : en proportion de 15 à 45% en poids, du copolymère du type éthylène/acrylate : en proportion de 15 à 50% en poids, de poly $\alpha$-oléfine amorphe : en proportion de 3 à 30% en poids, et du copolymère du type polyamide/polyéther : au moins 20% en poids.

FIG. 1

FIG. 2